# EUROPEAN PATENT APPLICATION

(11) **EP 2 913 364 A1**
(43) Date of publication of application: **02.09.2015**
(21) Application number: 15157294.8
(22) Date of filing: 28.11.2008
(51) Int. Cl.: C08L 83/06, C09D 183/06, H01L 21/312, G03F 7/075

(54) **Siloxane polymer compositions and methods of using the same**

(30) Priority: 30.11.2007 US 948274
(62) Divisional of application: 08855526.3
(71) Applicant: Optitune Oy, 90570 Oulu (FI)
(72) Inventor: Kärkäinen, Ari, 90570 Oulu (FI); Hannu-Kuure, Milja, 90570 Oulu (FI); Legrand, Sacha, 90570 Oulu (FI); Hadzic, Admir, 90570 Oulu (FI); Gordon, Graeme, 90570 Oulu (FI)
(74) Representative: Seppo Laine Oy

(57) **Abstract**

A siloxane composition and a method of producing the Same. The composition comprises a siloxane prepolymer with a backbone exhibiting a group which is capable of being deprotonated in an aqueous base solution. Further, there are reactive functional groups, which are capable of reacting during thermal or radiation initiated curing. The siloxane polymer is provided in a solvent which also contains a photo reactive compound. The composition can be used in negative tone lithographic fabrication processes where a water based developer system is applied in the development step of the lithography process.

## Description

### Background of the Invention

### Field of the Invention

The present invention relates to siloxane polymer compositions. In particular, the invention relates to siloxane polymer compositions which have suitable properties for use in negative tone lithographic fabrication processes. The invention also relates to synthesis, polymerization and cross-linking of such compositions.

### Description of Related Art

Photolithography is a common technique used in fabrication of semiconductor devices, such as integrated circuits (ICs), in flat panel display devices, such as liquid crystal displays, plasma displays, and organic light emitting displays, and in opto-electronic and photonic devices, such as waveguide and light-guide structures, gratings and photonic crystals.

In a photolithographic process, a layer of a photosensitive material is deposited on a substrate to form a coating. The deposited material layer is selectively exposed to some form of radiation, such as ultraviolet-light. An exposure tool and a mask or, in step-and-repeat projection-systems, a reticle are used to produce the desired selective exposure. The mask contains clear and opaque features that define the pattern to be created in the photosensitive material layer. The areas that are exposed to the light are made either soluble or insoluble by the use of a specific solvent known as a developer.

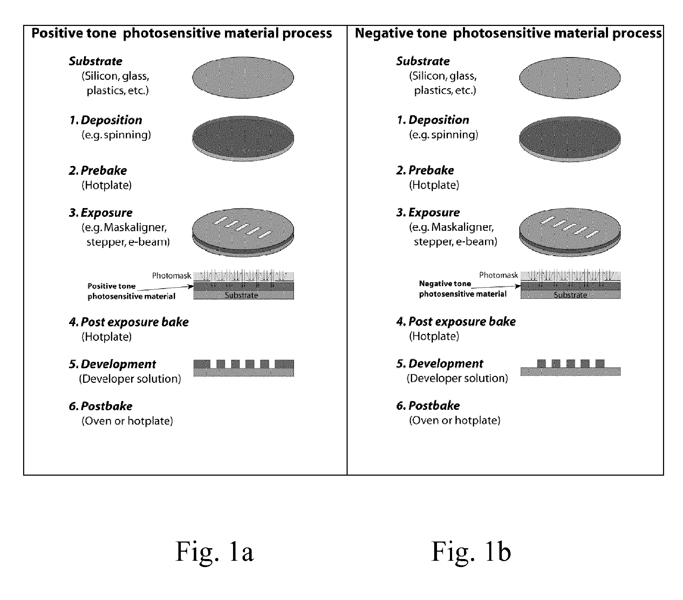

In the case where the irradiated (exposed) regions are soluble, a positive-image of the mask is produced in the photosensitive material. Such a material is called a positive tone photosensitive material [see attached Figure 1(a)].

If, on the other hand, the non-irradiated regions are dissolved by the developer, a negative-image results. The material in this case is called a negative tone photosensitive material [see Figure 1(b)].

Following the exposure the photosensitive material film must undergo a development step to turn the latent-image in the photosensitive material to the final image. In processes where the photosensitive material functions as a "sacrificial layer/structure", the areas of the photosensitive material that remain after development serve to mask the substrate regions which they cover in subsequent etching or ion-implantation steps.

Locations from which the photosensitive material has been removed can be subjected to a variety of subtractive or additive processes that transfer the pattern onto the substrate surface. In processes where the photosensitive material functions as an "active layer/structure", the areas of the photosensitive material that remain after development are used as they are in the final device/component structure and no additional etching or other subtractive or additive processes are needed.

Typically the positive tone photosensitive material developers are aqueous alkaline solutions, i.e. alkaline solutions diluted with water. To mention some typical examples: aqueous solutions of tetra methyl ammonium hydroxide (TMAH-water solutions) and potassium hydroxide (KOH-water solutions) are extensively used. These types of aqueous developers are favourable since they are commonly used by the industry and are also environmentally safe.

By contrast, the negative tone photosensitive material developers are typically organic solvent-based or -borne developers [e.g. acetone, isopropyl alcohol (IPA), methyl isobutyl ketone (MIBK), xylene and toluene] and this creates potentially severe environmental, health and safety (EHS) problems. Organic solvent-based developers are commonly used in lithographic processing of organo-siloxane polymer compositions. Typical developers that are used are acetone, IPA and MIBK. Water-soluble developers for negative tone siloxane materials have not been available.

### Summary of the Invention

It is an object of the present invention to remove at least a part of the problems relating to the art and to provide negative tone siloxane polymer compositions for aqueous basic developer systems.

In particular, it is an aim of the present invention to provide new material compositions that have suitable properties to be used in negative tone lithographic fabrication processes where water based developer system is applied in the development step of the lithography process.

It is second aim of the present invention to provide material compositions that are suitable to produce films and structures by using conventional and cost-efficient processing from the liquid phase, including spin-on, dip, spray, ink-jet, roll-to-roll, gravure, flexo-graphic, curtain, screen printing coating methods, extrusion coating and slit coating, but are not limited to these.

The patterning of the thermally and/or irradiation sensitive material compositions can be performed via direct lithographic patterning, conventional lithographic masking and etching procedure, imprinting and embossing, but are not limited to these.

It is a third aim of the invention to provide material compositions that can be cured at relatively low processing temperatures e.g. at a temperature of max 240 °C or even at temperature of 100 °C.

It is a fourth aim of the invention to provide material compositions that can be cured at temperatures up to 450 °C, or even up to 900 °C, making it possible for the compositions to be combined the material film or structures with following high temperature deposition steps, such as some sputtering, firing, thermal evaporation and/or CVD processes.

It is a sixth aim of the invention to provide a material composition that functions as optical layer in a display device (such as LCD, Plasma, OLED display), solar cell, LED or semiconductor device.

It is a seventh aim of the invention to provide material compositions that after film deposition (optionally patterning) and curing the material film or structures are capable of withstanding aggressive wet etching and dry etching process steps of any subsequent deposition/patterning process steps.

It is an eight aim of the invention to provide material compositions that are capable of performing as a planarization layer on a substrate or electronic device which may have protruding structures on top of it. This substrate may be part of a display device (e.g. liquid crystal display or plasma display or OLED display).

It is a ninth aim of the invention to provide material compositions that are capable of performing as an insulating layer on a substrate or in an electronic component. This insulating layer can also function simultaneously as a planarization layer on a substrate or in an electronic device. This substrate and/or electronic device (such as a thin film transistor) can be part of a display device (e.g. liquid crystal display or plasma display or OLED display).

It is a tenth aim of the invention to provide material compositions that can be deposited on various substrate surfaces, such as glass, silicon, silicon nitride, metals and plastics.

It has been found that when the siloxane polymer has a high content of groups that a capable of undergoing deprotonation in an alkaline environment, the siloxane polymer is easily dissolved into an base-water developer solution (e.g. in tetra methyl ammonium hydroxide, in the following also abbreviated "TMAH", or potassium hydroxide, KOH). Examples of such groups include hydroxyl, amino, thiol, and carboxyl. The groups capable of undergoing deprotonation can be attached directly to the silicon atoms of the siloxane polymer backbone or attached to organic functionalities which are attached to the siloxane polymer backbone. The siloxane polymer further exhibits reactive functional groups, e.g. amine, epoxy, acryloxy, allyl or vinyl groups. These reactive organic groups are capable of reacting during the thermal or radiation initiated curing step.

The deprotonating groups will be present in sufficient amount to make the polymer soluble in the basic developer solution. There will also be a sufficient amount of active reactive to provide for cross-linking as a result of UV exposure.

The method of producing a siloxane prepolymer composition, comprises
- hydrolysing at least two different silane monomers,
- condensating the silane monomers to form a siloxane polymer having a molecular weight of about 500 to 20,000 g/mol, and
- incorporating a photo reactive compound and a solvent for the siloxane polymer, in order to formulate a siloxane prepolymer liquid composition.

The present invention also provides a method of using a siloxane prepolymer composition in a lithography method, comprising
- optionally adjusting the solid contents of the prepolymer composition material to the required film thickness of the deposited film,
- depositing the composition on a substrate to form a layer having a film thicknesses of 10 nm- 10 µm,
- optionally heat treating the deposited film,
- subjecting the deposited material layer to lithography by using a photo mask or reticle and exposing the material to UV light,
- optionally heat treating the exposed material, and
- removing the non-exposed areas of the film are removed in a development step, by contacting the layer with an aqueous basic developer solution.

More specifically, the composition according to the present invention is characterized by what is stated in the characterizing part of claim 1.

The method according to the invention for producing the present compositions is characterized by what is stated in the characterizing part of claim 16.

The invention provides considerable advantages. Thus, the novel siloxanes are soluble in aqueous alkaline developers which are commonly used by industry and they are also environmentally safe.

### Brief Description of the Drawings

Figure 1a shows in a schematic fashion the main step of a lithographic process for a positive tone photosensitive material, and Figure 1b shows the same steps of the lithographic process for a negative tone photosensitive material process;
Figure 2 shows an SEM image of a lithographically patterned single line feature, formed by a patterned cured structure having a thickness of 1,5 µm, on a silicon substrate;
Figure 3 shows an SEM image of a lithographically patterned single line feature, formed by a patterned cured structure having a thickness of 4 µm, on a silicon substrate; and
Figure 4 shows a microscope image of the lithographically patterned single line feature, formed by a patterned cured structure having a thickness of 10 µm, on silicon substrate.

### Detailed Description of Preferred Embodiments

As mentioned already above the present invention relates generally to synthesis and polymerization of siloxane polymer compositions that have properties which make them suitable for use in negative tone lithographic fabrication processes.

In particular, the present invention provides synthesis and polymerizations methods of the siloxane or organo-siloxane polymer compositions which are applicable directly in manufacturing lines that use alkaline-aqueous based developer systems. For the purpose of the present invention, the terms "alkaline-aqueous" and "basic-aqueous" and "aqueous base" and similar are interchangeably used to designate aqueous solution that have a pH in excess of 7, preferably in excess of 9 and suitably about 11 to 14, in particular about 11 to 13 or 12 to 13. The basic component can be an alkali metal or earth alkaline metal hydroxide or metal carbonate, an amine or any other suitable alkaline/basic compound and combinations of two or more such substances.

In the present invention the novel material compositions are siloxane polymers, which in the following are also interchangeably called "prepolymers" because they will give rise to polymers having higher molecular weight during the lithographic process. The siloxane polymers/prepolymers are synthesized by using silane precursor molecules as starting materials. The polymers have a siloxane backbone comprising repeating units -Si-O-. Generally, in the formula (-Si-O-)ₙ the symbol n stands for an integer 2 to 1000, in particular about 3 to 100.

The molecular weight range for the prepolymer material is in range of 500 to 20,000, preferably about 700 to 15,000, in particular about 1000 to 10,000 g/mol.

The precursor molecules of the siloxane polymers can be tetra-, tri-, di-, or mono-functional molecules. A tetra-functional molecule has four hydrolysable groups; a trifunctional molecule has three hydrolysable groups; a di-functional molecule has two; and mono-functional molecule has one.

According to one particularly preferred embodiment, the trifunctional or tetra-functional alkoxide (alkoxysilane) residues in the polymer are derived from, e.g. tri (lower alkoxy)silanes or tetra(lower alkoxy)silanes, such as ethoxysilane or tetramethoxysilane or mixtures thereof. By using a large portion of these compounds (at least 40 mol % of the total amount of precursors), the silicon dioxide content of the final deposited film can be maximized. Naturally, it is also possible to use precursors, i.e. silane monomers having organic functionalities, in the precursor procedure.

In the above process, various silane monomers, and in particular combinations of silane monomers, can be used as precursors of the present organosiloxane polymers.

According to one embodiment, the process according to the invention comprises hydrolyzing and polymerizing a monomer according to either or both of formulas I and II:

R¹ₐSiX₄₋ₐ I

and

R²_{b}SiX_{4-b} II

wherein R¹ and R² are independently selected from the group consisting of hydrogen, linear and branched alkyl and cycloalkyl, alkenyl, alkynyl, (alk)acrylate, epoxy, allyl, vinyl and alkoxy and aryl having 1 to 6 rings;
each X represents independently a hydrolysable group or a hydrocarbon residue; and
a and b is an integer 1 to 3.

Further, in combination with monomers of formula I or II or as such at least one monomer corresponding to Formula III can be employed:

R³_{c}SiX_{4-c} III

wherein R³ stands for hydrogen, alkyl or cycloalkyl which optionally carries one or several substituents, or alkoxy;
each X represents independently a hydrolysable group or a hydrocarbon residue having the same meaning as above; and
c is an integer 1 to 3.

In any of the formulas above, the hydrolysable group is in particular an alkoxy group (cf. formula IV).

As discussed above, the present invention provides for the production of organosiloxane polymers using tri- or tetraalkoxysilane. The alkoxy groups of the silane can be identical or different and preferably selected from the group of radicals having the formula

-O-R⁴ IV

wherein R⁴ stands for a linear or branched alkyl group having 1 to 10, preferably 1 to 6 carbon atoms, and optionally exhibiting one or two substitutents selected from the group of halogen, hydroxyl, vinyl, epoxy and allyl.

The above precursor molecules are condensation polymerized to achieve the final siloxane polymer composition. Generally, in case of tri-, di- and mono- functional molecules, the other functional groups (depending on the number of hydrolysable group number) of the precursor molecules can be organic functionalities such as linear, aryl, cyclic, aliphatic groups. These organic groups can also contain reactive functional groups e.g. amine, epoxy, acryloxy, allyl or vinyl groups. These reactive organic groups can react during the thermal or radiation initiated curing step. Thermal and radiation sensitive initiators can be used to achieve specific curing properties from the material composition. When using the radiation sensitive initiators the material can perform as a negative tone photosensitive material in the lithography process.

According to a preferred embodiment, when using the above monomers, at least one of the monomers used for hydrolysation and condensation is selected from monomers having formulas I or II, wherein at least one substituent is an active group capable of achieving cross-linking to adjacent siloxane polymer chains upon a thermal or radiation initiated curing step. For preparing the prepolymer, the molar portion of units derived from such monomers (or the molar portion of monomers containing the active group calculated from the total amount of monomers) is about 0.1 to 70 %, preferably about 0.5 to 50 %, in particular about 1 to 40 %. In some cases, the active group will be present in a concentration of about 1 to 15 % based on the molar portion of monomers.

Particularly suitable monomers are selected from the group of triethoxysilane, tetraethoxysilane, methyltriethoxysilane, ethyltriethoxysilane, n-butyltriethoxysilane, methyldiethoxyvinylsilane, dimethyldiethoxysilane, phenyltrimethoxysilane, phenantrene-9-triethoxysilane, vinyltrimethoxysilane, 3-glysidoxypropyltrimethoxysilane, aminopropyltrimethoxysilane, methacryloxypropyltrimethoxisilane, acryloxypropyltrimethoxysilane, allyltrimethoxysilane, epoxycyclohexylethyltrimethoxysilane and mixtures thereof.

According to one embodiment, at least 50 mole-% of the monomers being selected from the group of tetraethoxysilane, methyltriethoxysilane, ethyltriethoxysilane, n-butyltriethoxysilane, methyldiethoxyvinylsilane and dimethyldiethoxysilane and mixtures thereof.

According to one embodiment, the siloxane composition comprises a siloxane prepolymer in a solvent phase, wherein
- the prepolymer has a siloxane backbone formed by repeating -Si-O- units and having a molecular weight in the range of from about 1,000 to about 10,000 g/mol, the siloxane backbone exhibiting hydroxyl groups in an amount of about 5 to 70 % of the -Si-O- units and further exhibiting epoxy groups in an amount of 1 to 15 mol %, calculated from the amount of repeating units; and
- the composition further comprises 0.1-3%, based on the weight of the solid matter, at least one cationic photo reactive compound.

The synthesis of the siloxane polymer is carried out in two steps. In the first synthesis step, in the following also called the hydrolysis step, the precursor molecules are hydrolyzed in presence typically of water and a catalyst, such as hydrochloric acid or another mineral or organic acid or a base, and in the second step, the polymerization step, the molecular weight of the material is increased by condensation polymerization. The water used in the hydrolysis step has typically a pH of less than 7, preferably less than 6, in particular less than 5.

During hydrolysation a partial condensation is started and a relatively low molecular weight prepolymer is formed. With some precursors and compositions it is possible that already at this synthesis stage the material may have a suitable molecular weight and properties to be used as the final material, and after addition of processing solvent, if needed, ready for film deposition and patterning.

In the second step, the obtained low molecular weight prepolymer is further condensation polymerized to yield a prepolymer having a molecular weight corresponding to the preselected range. It may be preferable in some cases to carry out the condensation in the presence of a suitable catalyst. In this step the molecular weight of the prepolymer is increased to facilitate suitable properties of the material and film deposition and processing.

The siloxane polymer synthesis, including the hydrolysis and condensation reactions, can be carried out using an inert solvent or inert solvent mixture, such as acetone or PGMEA, "non-inert solvent", such as alcohols, or without a solvent. The used solvent affects the final siloxane polymer composition. The reaction can be carried out in basic, neutral or acidic conditions in the presence of a catalyst. The hydrolysis of the precursors may be done in the presence of water (excess of water, stoichiometric amount of water or sub-stoichiometric amount of water). Heat may be applied during the reaction and refluxing can be used during the reaction.

Before further condensation the excess of water is removed from the material and at this stage it is possible to make a solvent exchange to another synthesis solvent if desired. This other synthesis solvent may function as the final or one of the final processing solvents of the siloxane polymer. The residual water and alcohols and other by-products may be removed after the further condensation step is finalized. Additional processing solvent(s) may be added during the formulation step to form the final processing solvent combination. Additives such as thermal initiators, radiation sensitive initiators, surfactants and other additives may be added prior to final filtration of the siloxane polymer. After the formulation of the composition, the polymer is ready for processing in, for example, a lithographic process.

By adjusting the hydrolysis and condensation conditions it is possible to control the concentration/content of the group capable of being deprotonated (e.g. an OH-group) and any residual leaving groups from the silane precursors (e.g. alkoxy groups) of the siloxane polymer composition and also to control the final molecular weight of the siloxane polymer. This greatly affects dissolution of the siloxane polymer material into the aqueous based developer solution.

Thus, for example, it has been found that when the final siloxane polymer has a high content of hydroxyl groups remaining and a low content of alkoxy (e.g. ethoxy) groups, the final siloxane polymer is easily dissolved into an alkaline-water developer solution (e.g. tetra methyl ammonium hydroxide; TMAH, or potassium hydroxide; KOH).

On the other hand if the remaining alkoxy-group content of the final siloxane polymer is high and it contains hardly any OH-groups, the final siloxane polymer has a very low solubility in an alkaline-water developer of the above kind. The OH-groups or other functional groups, such as amino (NH₂), thiol (SH), carboxyl or similar that result in solubility to the alkaline developer systems, can be attached directly to the silicon atoms of the siloxane polymer backbone or optionally attached to organic functionalities attached into the siloxane polymer backbone.

Hydroxy groups can be introduced into the siloxane polymer during the hydrolysis step. Amino, thiol and other groups can be incorporated by selecting a silane monomer which contains such groups. As an example of such a monomer, aminopropyltriethoxysilane can be mentioned.

Generally there will be at least about 1 deprotonating group/100 silicon atoms or -Si-O-units, preferably there is about 1 deprotonating group/50 -Si-O- units up to 10 deprotonating groups/10 -Si-O- units. Particularly preferred is from about 1 deprotonating group/20 -Si-O- units up to about 8 deprotonating groups/10 -Si-O- units. This way, the unexposed areas of the layer can easily be dissolved in the basic aqueous developer solution.

Suitable solvents for the synthesis are, for example, acetone, tetrahydrofuran (THF), toluene, 2-propanol, methanol, ethanol, propylene glycol monomethyl ether, propylene glycol propyl ether, methyl-tert-butylether (MTBE), propylene glycol monomethylether acetate (PGMEA), propylene glycol monomethylether PGME and propylene glycol propyl ether (PnP).

The organosiloxane polymer can be recovered in the reaction medium.

After synthesis, the material is diluted using a proper solvent or solvent combination to give a solids content which in film deposition will yield the pre-selected film thickness.

Usually, an initiator molecule compound is added to the siloxane composition. The initiator is used for creating a species that can initiate the polymerization of the "active" functional group in the UV curing step. In case of an epoxy group, cationic or anionic initiators can be used. In case of a group with double bonds as "active" functional group in the synthesized material, radical initiators can be employed. Also thermal initiators (working according to the radical, cationic or anionic mechanism) can be used to facilitate the cross-linking of the "active" functional groups. The choice of a proper combination of the photoinitiators also depends on the used exposure source (wavelength).

The concentration of the photo reactive compound in the composition is generally about 0.1 to 10 %, preferably about 0.5 to 5 %, calculated from the mass of the siloxane polymer. According to one embodiment, the organosiloxane polymer is formulated into a composition comprising at least about 20 mole-% of an organic hydroxyl compound.

Film thicknesses may range e.g. from 5 nm to 10 µm. Various methods of producing thin films are described in U.S. Patent No. 7,094,709, the contents of which are herewith incorporated by reference.

A film produced according to the invention typically has a dielectric constant of 4 or below at a frequency of 100 kHz. The index of refraction lies between 1.2 to 1.9 at a wavelength of 633 nm.

Furthermore, the films exhibit a cross-linking degree of 70 % or more at a UV dose of 100 mJ/cm² or less at I-line wavelength of mercury UV source.

The final coating film thickness has to be optimized according for each device and structure fabrication process. When, for example, PGMEA is employed as solvent for the synthesis, in one or both of the above-described the synthesis steps, it is not necessary to change the solvent for the final material, since PGMEA is regularly used also as a processing solvent in the semiconductor industry. This makes the synthesis procedure of the material easier and less time consuming.

We are able to conclude that when the OH-/alkoxy-group ratio in final siloxane polymer is in the range of 5:95 to 95:5, preferable between 10:90 to 90:10, the material will be well suited to be used together with alkaline-water based developers. It should be noted that the final siloxane polymer molecular weight also has an effect on the ability of the alkaline developer to dissolve the siloxane polymer during the lithography process.

The composition as described above may comprise solid nanoparticles in an amount of between 5 and 50 wt-% of the composition. The nanoparticles are in particular selected from the group of light scattering pigments and inorganic phosfors.

By means of the invention, materials are provided which are suitable for produce films and structures. The layers can be deposited on various substrate surfaces, such as glass, silicon, silicon nitride, metals and plastics.

The layers can be obtained by conventional and cost-efficient processing from the liquid phase. Such processing methods include spin-on, dip, spray, ink-jet, roll-to-roll, gravure, flexo-graphic, curtain, screen printing coating methods, extrusion coating and slit coating, but are not limited to these.

The patterning of the thermally and/or irradiation sensitive material compositions can be performed via direct lithographic patterning, conventional lithographic masking and etching procedure, imprinting and embossing, but are not limited to these.

The compositions can be used for making layers which are cured at relatively low processing temperatures, e.g. at temperatures of max 240 °C or even at temperature of 100 °C and in the range between these limits.

However, the layers formed from the compositions can also be cured at higher temperatures, i.e. temperatures over 240 and up to 450 °C, or even up to 900 °C. In such case, the films or structures produced from the compositions can be combined with a subsequent high temperature deposition step, such as sputtering, firing, thermal evaporation and/or a CVD process.

After film deposition (optionally patterning) and curing, the material film or structures are capable of withstanding aggressive wet etching and dry etching process steps of any subsequent deposition/patterning process steps.

The layers deposited from the compositions and cured as explained can perform as a planarization layer on a substrate or electronic device which may have protruding structures on top of it. This substrate may be part of a display device (e.g. liquid crystal display or plasma display or OLED display).

Generally, the material composition can function as optical layers in display devices (such as LCD, Plasma, OLED display), solar cell, LED or semiconductor devices.

It is also possible to use the compositions for making insulating layers on a substrate or in an electronic component. This insulating layer can also function simultaneously as a planarization layer on a substrate or in an electronic device. This substrate and/or electronic device (such as a thin film transistor) can be part of a display device (e.g. liquid crystal display or plasma display or OLED display).

In the following, the invention will be illustrated with the aid of a number of working examples giving further details of the preparation of the above-discussed siloxane polymer coating compositions.

### Example 1

Methyltriethoxysilane (1440 g, 90 mol %) and 3-glysidoxypropyltrimethoxysilane (211.84 g, 10 mol %) were weighed to a round bottom flask. 3303.68 g of acetone was added to the round bottom flask. 969.28 g of water (0.01 M HNO₃) was added to the reaction flask within 5 min, while constantly stirring the reaction mixture using a magnetic stirrer. After this the reaction mixture was stirred at room temperature (in the following abbreviated "RT") for 17 min and refluxed for 5 hours using electric mantel. After the refluxing, most of the acetone was removed from the reaction mixture using a rotary evaporator (pressure 350 -> 250 mbar, t(bath) = 50 °C). After most of the acetone had been removed, 250 g of PGMEA was added to the flask. The reaction mixture was evaporated further in the rotary evaporator (pressure 45mbar, t(bath) = 50 °C, 1 hour) after PGMEA addition to perform a solvent exchange. After the solvent exchange the material solution was refluxed at 120 °C for 1 hour. After this time the material was ready for use after formulation (addition of solvents and additives) and filtration. The material was formulated to certain solid content depending on the film thickness requirements (see below) and filtrated using 0.1µm PTFE filter. The solution was ready for use for processing in a lithographic process as will be described below in more detail.

### Example 2

Methyltriethoxysilane (120 g, 90 mol %) and Vinyltriethoxysilane (14.22 g, 10 mol %) were weighed to a round bottom flask. 268.44 g of acetone was added to the round bottom flask. 80.83 g of water (0.01 M HNO₃) was added to the reaction flask within 5 min, while constantly stirring the reaction mixture using a magnetic stirrer. After this the reaction mixture was stirred at RT for 17 min and refluxed for 5 hours using electric mantel. After the refluxing, most of the acetone was removed from the reaction mixture using a rotary evaporator (pressure 350 -> 250 mbar, t(bath) = 50 °C). After most of the acetone was removed, 89.83 g of PGMEA was added to the flask. The reaction mixture was evaporated further in the rotary evaporator (pressure 45 mbar, t(bath) = 50 °C, 1 hour) after PGMEA addition to perform a solvent exchange. After the solvent exchange the material solution was refluxed at 120 °C for 1 hour. After the 1 hour refluxing step the material is ready for use after formulation (addition of solvents and additives) and filtration. The material is formulated to certain solid content depending on the film thickness requirements and filtrated using 0.1 µm PTFE filter. The solution is ready for use for processing.

### Example 3

Methyltriethoxysilane (30 g, 80 mol %), 3-glysidoxypropyltrimethoxysilane (4.97 g, 10 mol %) and Phenyltrimethoxysilane (4.17 g, 10 mol %) were weighed to a round bottom flask. 78.28 g of acetone was added to the round bottom flask. 22.73 g of water (0.01 M HCl) was added to the reaction flask within 5 min, while constantly stirring the reaction mixture using a magnetic stirrer. After this the reaction mixture was stirred at RT for 17 min and refluxed for 5 hours using electric mantel. After the refluxing, most of the acetone was removed from the reaction mixture using a rotary evaporator (pressure 300 -> 200 mbar, t(bath) = 50 °C). After most of the acetone was removed, 32 g of PGMEA was added to the flask. The reaction mixture was evaporated further in the rotary evaporator (pressure 45 mbar, t(bath) = 50 °C, 1 hour) after PGMEA addition to perform a solvent exchange. After the solvent exchange the material solution was refluxed at 120 °C for 1 hour. After the 1 hour refluxing step the material is ready for use after formulation (addition of solvents and additives) and filtration. The material is formulated to certain solid content depending on the film thickness requirements and filtrated using 0.1µm PTFE filter. The solution is ready for use for processing.

### Example 4

Methyltriethoxysilane (30 g, 80 mol %), 3-glysidoxypropyltrimethoxysilane (5.68 g, 10 mol %) and Phenyltrimethoxysilane (9.53 g, 20 mol %) were weighed to a round bottom flask. 90.42 g of acetone was added to the round bottom flask. 25.98 g of water (0.01 M HCl) was added to the reaction flask within 5 min, while constantly stirring the reaction mixture using a magnetic stirrer. After this the reaction mixture was stirred at RT for 26 min and refluxed for 5 hours using electric mantel. After the refluxing, most of the acetone was removed from the reaction mixture using a rotary evaporator (pressure 800 -> 250 mbar, t(bath) = 50 °C). After most of the acetone was removed, 36.7g of PGMEA was added to the flask. The reaction mixture was evaporated further in the rotary evaporator (pressure 45mbar, t(bath) = 50°C, 1 hour) after PGMEA addition to perform a solvent exchange. After the solvent exchange the material solution was refluxed at 120 °C for 1 hour. After the 1 hour refluxing step the material is ready for use after formulation (addition of solvents and additives) and filtration. The material is formulated to certain solid content depending on the film thickness requirements and filtrated using 0.1 µm PTFE filter. The solution is ready for use for processing.

### Example 5

Methyltriethoxysilane (70 g, 70 mol %) and 3-glysidoxypropyltrimethoxysilane (39.76 g, 30 mol %) were weighed to a round bottom flask. 219.52 g of acetone was added to the round bottom flask. 60.58 g of water (0.01 M HCl) was added to the reaction flask within 4 min, while constantly stirring the reaction mixture using a magnetic stirrer. After this the reaction mixture was stirred at RT for 26 min and refluxed for 5 hours using electric mantel. After the refluxing, most of the acetone was removed from the reaction mixture using a rotary evaporator (pressure 350 -> 150 mbar, t(bath) = 50°C). After most of the acetone was removed, 60 g of PGMEA was added to the flask. The reaction mixture was evaporated further in the rotary evaporator (pressure 45mbar, t(bath) = 50 °C, 1 hour) after PGMEA addition to perform a solvent exchange. After the solvent exchange the material solution was refluxed at 120 °C for 1 hour. After the 1 hour refluxing step the material is ready for use after formulation (addition of solvents and additives) and filtration. The material is formulated to certain solid content depending on the film thickness requirements and filtrated using 0.1µm PTFE filter. The solution is ready for use for processing.

### Example 6

Methyltriethoxysilane (60 g, 80 mol %), 3-glysidoxypropyltrimethoxysilane (9.94 g, 10 mol %) and Phenanthrene-9-triethoxysilane (14.36 g, 10 mol %) were weighed to a round bottom flask. 164.6 g of acetone was added to the round bottom flask. 45.47 g of water (0.01 M HCl) was added to the reaction flask within 4 min, while constantly stirring the reaction mixture using a magnetic stirrer. After this the reaction mixture was stirred at RT for 26 min and refluxed for 5 hours using electric mantel. After the refluxing, most of the acetone was removed from the reaction mixture using a rotary evaporator (pressure 800 -> 150 mbar, t(bath) = 50 °C). After most of the acetone was removed, 55.0g of PGMEA was added to the flask. The reaction mixture was evaporated further in the rotary evaporator (pressure 45 mbar, t(bath) = 50 °C, 1 hour) after PGMEA addition to perform a solvent exchange. After the solvent exchange the material solution was refluxed at 120 °C for 1 hours. After the 1 hour refluxing step the material is ready for use after formulation (addition of solvents and additives) and filtration. The material is formulated to certain solid content depending on the film thickness requirements and filtrated using 0.1 µm PTFE filter. The solution is ready for use for processing.

### Example 7

Methyltriethoxysilane (17.14 g, 40mol %), 3-glysidoxypropyltrimethoxysilane (22.31 g, 30 mol %) and isobutyltrimethoxysilane (16.38 g, 30 mol %) were weighed to a round bottom flask. 281.4 g of acetone was added to the round bottom flask. 17.0 g of water (0.01 M HCl) was added to the reaction flask within 4 min, while constantly stirring the reaction mixture using a magnetic stirrer. After this the reaction mixture was stirred at RT for 26 min and refluxed for 1 hour using electric mantel. After the refluxing, most of the acetone was removed from the reaction mixture using a rotary evaporator (pressure 800 -> 150 mbar, t(bath) = 50 °C). After most of the acetone was removed, 198.28 g of PGMEA was added to the flask. The reaction mixture was evaporated further in the rotary evaporator (pressure 45 mbar, t(bath) = 50 °C, 1 hour) after PGMEA addition to perform a solvent exchange. After the solvent exchange the material solution was refluxed at 120 °C for 24 hours. After the refluxing the material it is ready for use after formulation (addition of solvents and additives) and filtration. The material is formulated to certain solid content depending on the film thickness requirements and filtrated using 0.1 µm PTFE filter. The solution is ready for use for processing.

### Example 8

Methyltriethoxysilane (31.87 g, 85 mol %), 3-glysidoxypropyltrimethoxysilane (4.97 g, 10 mol %) and Phenyltrimethoxysilane (2.09 g, 5 mol %) were weighed to a round bottom flask. 77.86 g of acetone was added to the round bottom flask. 22.73 g of water (0.01 M HCl) was added to the reaction flask within 5 min, while constantly stirring the reaction mixture using a magnetic stirrer. After this the reaction mixture was stirred at RT for 26 min and refluxed for 5 hours using electric mantel. After the refluxing, most of the acetone was removed from the reaction mixture using a rotary evaporator (pressure 350 -> 250 mbar, t(bath) = 50 °C). After most of the acetone was removed, 31.34 g of PGMEA was added to the flask. The reaction mixture was evaporated further in the rotary evaporator (pressure 45mbar, t(bath) = 50 °C, 1 hour) after PGMEA addition to perform a solvent exchange. After the solvent exchange the material solution was refluxed at 120 °C for 1 hours. After the 1 hour refluxing step the material is ready for use after dilution and filtration. The material was diluted to 20 % solid content and filtrated using 0.1 µm PTFE filter. The solution was ready for use for processing.

### Example 9

Methyltriethoxysilane (42.51 g, 85 mol %), 3-glysidoxypropyltrimethoxysilane (3.31 g, 5 mol %) and triethoxysilane (4.60 g, 10 mol %) were weighed to a round bottom flask. 100.84 g of acetone was added to the round bottom flask. 30.29 g of water (0.01 M HCl) was added to the reaction flask within 4 min, while constantly stirring the reaction mixture using a magnetic stirrer. After this the reaction mixture was stirred at RT for 26 min and refluxed for 5 hours using electric mantel. After the refluxing, most of the acetone was removed from the reaction mixture using a rotary evaporator (pressure 350 -> 250 mbar, t(bath) = 50 °C). After most of the acetone was removed, 60 g of PGMEA was added to the flask. The reaction mixture was evaporated further in the rotary evaporator (pressure 45 mbar, t(bath) = 50 °C, 1 hour) after PGMEA addition to perform a solvent exchange. After the solvent exchange the material solution was refluxed at 120 °C for 1 hours. After the 1 hour refluxing step the material is ready for use after formulation (addition of solvents and additives) and filtration. The material is formulated to certain solid content depending on the film thickness requirements and filtrated using 0.1µm PTFE filter. The solution is ready for use for processing.

### Example 10

Methyltriethoxysilane (20 g, 50 mol %) and 3-glysidoxypropyltrimethoxysilane (26.51 g, 50 mol %) were weighed to a round bottom flask. 139.53 g of acetone was added to the round bottom flask. 24.23 g of water (0.01 M HCl) was added to the reaction flask within 5 min, while constantly stirring the reaction mixture using a magnetic stirrer. After this the reaction mixture was stirred at RT for 17 min and refluxed for 5 hours using electric mantel. After the refluxing, most of the acetone was removed from the reaction mixture using a rotary evaporator (pressure 350 -> 250 mbar, t(bath) = 50 °C). After most of the acetone was removed, 14 g of PGMEA was added to the flask. The reaction mixture was evaporated further in the rotary evaporator (pressure 45mbar, t(bath) = 50 °C, 1 hour) after PGMEA addition to perform a solvent exchange. The material is ready for use after formulation (addition of solvents and additives) and filtration. The material is formulated to certain solid content depending on the film thickness requirements and filtrated using 0.1 µm PTFE filter. The solution is ready for use for processing.

### Example 11

Methyltriethoxysilane (20.0 g, 70 mol %), 3-glysidoxypropyltrimethoxysilane (7.57 g, 20 mol %) and tetraethoxysilane (3.34 g, 10 mol %) were weighed to a round bottom flask. 92.73 g of acetone was added to the round bottom flask. 17.31 g of water (0.01 M HCl) was added to the reaction flask within 4 min, while constantly stirring the reaction mixture using a magnetic stirrer. After this the reaction mixture was stirred at RT for 26 min and refluxed for 5 hours using electric mantel. After the refluxing, most of the acetone was removed from the reaction mixture using a rotary evaporator (pressure 350 -> 250 mbar, t(bath) = 50 °C). After most of the acetone was removed, 10g of PGMEA was added to the flask. The reaction mixture was evaporated further in the rotary evaporator (pressure 45mbar, t(bath) = 50 °C, 1 hour) after PGMEA addition to perform a solvent exchange. The material is ready for use after formulation (addition of solvents and additives) and filtration. The material is formulated to certain solid content depending on the film thickness requirements and filtrated using 0.1 µm PTFE filter. The solution is ready for use for processing.

### Example 12

Methyltriethoxysilane (40.0 g, 80 mol %), 3-glysidoxypropyltrimethoxysilane (6.62 g, 10 mol %) and triethoxysilane (4.60 g, 10 mol %) were weighed to a round bottom flask. 102.44 g of acetone was added to the round bottom flask. 30.29 g of water (0.01 M HCl) was added to the reaction flask within 4 min, while constantly stirring the reaction mixture using a magnetic stirrer. After this the reaction mixture was stirred at RT for 26 min and refluxed for 5 hours using electric mantel. After the refluxing, most of the acetone was removed from the reaction mixture using a rotary evaporator (pressure 350 -> 250 mbar, t(bath) = 50 °C). After most of the acetone was removed, 60 g of PGMEA was added to the flask. The reaction mixture was evaporated further in the rotary evaporator (pressure 45mbar, t(bath) = 50 °C, 1 hour) after PGMEA addition to perform a solvent exchange. After the solvent exchange the material solution was refluxed at 120 °C for 1 hour. After the 1 hour refluxing step the material is ready for use after formulation (addition of solvents and additives) and filtration. The material is formulated to certain solid content depending on the film thickness requirements and filtrated using 0.1 µm PTFE filter. The solution is ready for use for processing.

### Example 13

Naphthalene-1-triethoxysilane (30.0 g, 80 mol %), 3-glysidoxypropyltrimethoxysilane (3.48 g, 10 mol %) and triethoxysilane (2.42 g, 10 mol %) were weighed to a round bottom flask. 71.80 g of acetone was added to the round bottom flask. 15.90 g of water (0.01 M HCl) was added to the reaction flask within 3 min, while constantly stirring the reaction mixture using a magnetic stirrer. After this the reaction mixture was stirred at RT for 26 min and refluxed for 5 hours using electric mantel. After the refluxing, most of the acetone was removed from the reaction mixture using a rotary evaporator (pressure 350 -> 250 mbar, t(bath) = 50 °C). After most of the acetone was removed, 60 g of PGMEA was added to the flask. The reaction mixture was evaporated further in the rotary evaporator (pressure 45mbar, t(bath) = 50 °C, 1 hour) after PGMEA addition to perform a solvent exchange. After the solvent exchange the material solution was refluxed at 120 °C for 1 hours. After the 1 hour refluxing step the material is ready for use after formulation (addition of solvents and additives) and filtration. The material is formulated to certain solid content depending on the film thickness requirements and filtrated using 0.1 µm PTFE filter. The solution is ready for use for processing.

### Example 14

Methyltriethoxysilane (30.0 g, 60 mol %), 3-glysidoxypropyltrimethoxysilane (19.88 g, 30 mol %) and triethoxysilane (4.60 g, 10 mol %) were weighed to a round bottom flask. 108.96 g of acetone was added to the round bottom flask. 30.29 g of water (0.01 M HCl) was added to the reaction flask within 4 min, while constantly stirring the reaction mixture using a magnetic stirrer. After this the reaction mixture was stirred at RT for 26 min and refluxed for 5 hours using electric mantel. After the refluxing, most of the acetone was removed from the reaction mixture using a rotary evaporator (pressure 350 -> 250 mbar, t(bath) = 50 °C). After most of the acetone was removed, 60g of PGMEA was added to the flask. The reaction mixture was evaporated further in the rotary evaporator (pressure 45 mbar, t(bath) = 50 °C, 1 hour) after PGMEA addition to perform a solvent exchange. After the solvent exchange the material solution was refluxed at 120 °C for 1 hour. After the 1 hour refluxing step the material is ready for use after formulation (addition of solvents and additives) and filtration. The material is formulated to certain solid content depending on the film thickness requirements and filtrated using 0.1 µm PTFE filter. The solution is ready for use for processing.

### Example 15

Methyltriethoxysilane (90 g, 90 mol %) and epoxycyclohexylethyltrimethoxysilane (13.82 g, 10 mol %) were weighed to a round bottom flask. 207.64 g of acetone was added to the round bottom flask. 60.58 g of water (0.01 M HCl) was added to the reaction flask within 3 min, while constantly stirring the reaction mixture using a magnetic stirrer. After this the reaction mixture was stirred at RT for 27 min and refluxed for 5 hours using electric mantel. After the refluxing, most of the acetone was removed from the reaction mixture using a rotary evaporator (pressure 350 -> 250 mbar, t(bath) = 50 °C). After most of the acetone was removed, 14 g of PGMEA was added to the flask. The reaction mixture was evaporated further in the rotary evaporator (pressure 45mbar, t(bath) = 50 °C, 1 hour) after PGMEA addition to perform a solvent exchange. After the solvent exchange the material solution was refluxed at 120 °C for 1 hour. After the 1 hour refluxing step the material is ready for use after formulation (addition of solvents and additives) and filtration. The material is formulated to certain solid content depending on the film thickness requirements and filtrated using 0.1µm PTFE filter. The solution is ready for use for processing.

### Example 16

Methyltriethoxysilane (1440 g, 90 mol %) and 3-glysidoxypropyltrimethoxysilane (211.84 g, 10 mol %) were weighed to a round bottom flask. 3305 g of acetone was added to the round bottom flask. 970 g of water (0.01 M HNO₃) was added to the reaction flask within 5 min, while constantly stirring the reaction mixture using a magnetic stirrer. After this the reaction mixture was stirred at RT for 23 min and refluxed for 5 hours using electric mantel. After the refluxing, most of the acetone was removed from the reaction mixture using a rotary evaporator (pressure 350 -> 250 mbar, t(bath) = 50 °C). After most of the acetone was removed, 270 g of PGME was added to the flask. The reaction mixture was evaporated further in the rotary evaporator (pressure 45mbar, t(bath) = 50 °C, 1 hour) after PGME addition to perform a solvent exchange. After the solvent exchange the material solution was refluxed at 120 °C for 1 hours. After the 1 hour refluxing step the material is ready for use after formulation (addition of solvents and additives) and filtration. The material is formulated to certain solid content depending on the film thickness requirements and filtrated using 0.1 µm PTFE filter. The solution is ready for use for processing.

### Example 17

Methyltriethoxysilane (1440g, 90 mol %) and 3-glysidoxypropyltrimethoxysilane (211.84 g, 10 mol %) were weighed to a round bottom flask. 3305 g of acetone was added to the round bottom flask. 960 g of water (0.01 M HNO₃) was added to the reaction flask within 5 min, while constantly stirring the reaction mixture using a magnetic stirrer. After this the reaction mixture was stirred at RT for 23 min and refluxed for 5 hours using electric mantel. After the refluxing, most of the acetone was removed from the reaction mixture using a rotary evaporator (pressure 350 -> 250 mbar, t(bath) = 50 °C). After most of the acetone was removed, 260 g of PnP was added to the flask. The reaction mixture was evaporated further in the rotary evaporator (pressure 45mbar, t(bath) = 50 °C, 1 hour) after PnP addition to perform a solvent exchange. After the solvent exchange the material solution was refluxed at 120 °C for 1 hours. After the 1 hour refluxing step the material is ready for use after formulation (addition of solvents and additives) and filtration. The material is formulated to certain solid content depending on the film thickness requirements and filtrated using 0.1µm PTFE filter. The solution is ready for use for processing.

By selection of precursor materials and the used composition it is possible to vary the material's final properties (optical, mechanical, chemical). The selection of the synthesis and processing solvents for the material affects also to the final material properties. As mentioned before it is possible to use either inert or reactive solvent during the synthesis and/or as processing solvents. The selection of a proper solvent affects to the resulting composition of the polymer after synthesis, stability of the final composition, dissolution rate of the material in the lithography process, deposited film quality, lithography process parameters. With some compositions it may be preferable to use a reactive solvent as processing solvent which is capable of reacting (covalently bonding or coordinating) with the synthesized siloxane composition. As an example of these reactive solvent can be PGME, PnP, 2-propanol, Water (H₂O), ethanol, methanol, ethyl lactate. In addition to the above represented compositions, other composition variations can be synthesized based on these methods and wide range of properties can be achieved.

### Lithography process for the material of Example 1:

After the synthesis of the material (described above in Example 1), the material is formulated to a solid contents which is adjusted depending on the required film thickness of the deposited film. The resulting film thickness is also dependent on the used deposition method (e.g. dip coating, spin coating, spray coating, slot coating) and has to be optimized case by case. Also the used processing solvent affects the resulting film thickness. By using spin-coating and propylene glycol monomethyl ether acetate (PGMEA) as processing solvent the material film thickness can be varied between 10 nm - 10 µm, formulating the solid content between 1 - 65 %, respectively. Even thicker structures can be achieved by using higher solid content. Low boiling point solvents should be selected as process solvents when low curing temperatures are required. Other additives such as surfactants (e.g. Byk-307 and FC 4430 or 4432) can be also used if needed.

In Example 1 the material has an epoxy functionality (obtained from the 3-glysidoxypropyltrimethoxysilane precursor molecule) that can facilitate the polymerization during the UV curing step.

In addition to this "active" functional group (the epoxy group) in the synthesized material, an initiator molecule has to be used to create a species that can initiate the polymerization of the "active" functional group in the UV curing step. In case of an epoxy group, cationic or anionic initiators are used (such as Rhodorsil Photoinitiator 2074 and Cyracure Photoinitiator UVI-6976).

When using for example double bonds as the "active" functional group in the synthesized material, radical initiators (such as Ircacure 819, 814 and 651) are used to facilitate the polymerization during the UV curing step. Also thermal initiators (radical, cationic or anionic) can be used to facilitate the cross-linking of the "active" functional groups. The choice of a proper combination of the photoinitiators also depends on the used exposure source (wavelength).

The additive and photoinitiator concentrations are calculated from the solid content of the final siloxane polymer composition. The material works as a negative tone resist material, meaning that the material is polymerized in areas where exposed and becomes insoluble in the developer solution used. When the processing solvents and additives are added, the material is filtrated using 0.1µm+ 0.04µm PTFE filters. The solution is ready for use for processing. Below are represented three different processes to result in different film thicknesses.

Process Example A for the synthesis example 1 (to results in 1.5 µm film thickness):

### Formulation and additives

- Formulated to 32 % solid content using PGMEA
- 1 % UVI 6976 photo initiator
- 1 % Rhodorsil photo/thermal initiator
- 0.05 % BYK307 Surfactant

### Spin coating

- Dispense on a slowly rotating substrate (dynamic dispensing)
- Rotate at 50 rpm for 5 seconds
- Rotate at 300 rpm for 10 seconds
- Rotate at final speed (e.g. 1500 rpm) for 30 seconds
- EBR/Backside rinse (e.g. 600 rpm), 30 seconds

### Soft Bake

After deposition of the material, a soft bake process is used. Both convection oven and hotplate bake methods may be applied.
- Place on a hot plate at 140 °C for 1 min

### Cool plate

The substrate should be cooled before the exposure step.
- Place on a cool plate for 1 min

### Exposure

The deposited material layer is lithographically patterned using a photo mask or reticle and UV-exposure step. The material works as a negative tone resist material.
- Exposure source: a mercury UV-lamp (10.3 mW/cm², broadband) or I-line stepper (I-line exposure)
- Exposure time for 5-10 seconds is a typical process

### Post Exposure Bake

After exposing the material layer through, a post exposure bake process should be used. Both convection oven and hotplate bake methods may be applied. The substrate should be cooled before the development step.
- Place on the hot plate at 90°C for 10 seconds.

### Development (alkaline developer, such as TMAH water solution)

After exposing and post exposure baking the material layer, the non-exposed areas of the film are removed in the development step, by dipping (or using a puddle development method) the film into the developer solution. The Developer AZ326 MIF 1:3 ratio with DI water can be used for the development of the film.
- Develop in a 1:3 solution (AZ 326 MIF Developer: DI Water) for 1 min

### Hard Bake / Cure

The cure temperature may be higher than 250°C when the coating is to be subjected to a high temperature process after curing. However, lower cure temperatures are commonly applied and the material is stable and cured at temperatures such as < 250°C. In convection oven (N₂, atmosphere):
- ramp within 30 minutes to 150 °C hold for 30 minutes
- ramp within 30 minutes to 250 °C hold for 2 hours
- ramp down slowly
- On hot plate at 250 °C for 5 minutes

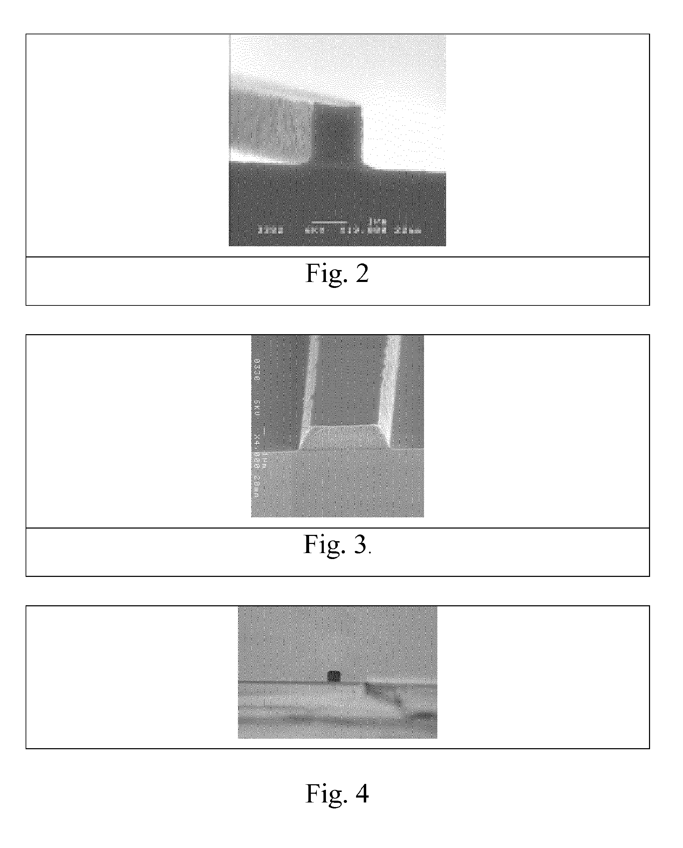

The resulting patterned cured structure has a thickness of 1.5 µm. Figure 2 shows an SEM image of the lithographically patterned single line feature on a silicon substrate.

Process example B for the synthesis example 1 (to produce a film thickness of 4 µm):

### Formulation and additives

- Formulated to 50 % solid content using PGMEA
- 1 % UVI 6976 photo initiator
- 1 % Rhodorsil photo/thermal initiator
- 0.05 % BYK307 surfactant

Otherwise the process is exactly similar to the case of Process Example A. The resulting patterned cured structure has a thickness of 4µm. Figure 3 shows an SEM image of the lithographically patterned single line feature on a silicon substrate.

Process Example C for Synthesis Example 1 (to produce a film thickness of 10 µm):

### Formulation and additives

- Formulated to a 65 % solid content using PGMEA
- 1% UVI 6976 photo initiator
- 1 % Rhodorsil photo/thermal initiator
- 0.05 % BYK307 Surfactant

Otherwise the process is exactly similar to the case of Process Example A. The resulting patterned cured structure has a thickness of 10 µm. Figure 4 shows a microscope image of the lithographically patterned single line feature on a silicon substrate.

## Claims

1. A siloxane composition, comprising
- a siloxane prepolymer with a siloxane backbone exhibiting a group which is capable of being deprotonated in an aqueous base solution and further exhibiting a reactive functional group, which is capable of reacting during a thermal or radiation initiated curing step,
- a solvent for the siloxane prepolymer and
- a photo reactive compound,
wherein the siloxane prepolymer has an average molecular weight of about 500 to 20,000 g/mol, in particular about 1,000 to 10,000 g/mol.

2. The composition according to claim 1, having a solid concentration of at least 1 weight-% and up to about 70 weight-%.

3. The composition according to claim 1 or 2, wherein the organosiloxane polymer contains at least 1 mole-%, in particular at least 5 mole-% units derived from monomers comprising at least one group which is capable of being deprotonated.

4. The composition of any of claims 1 to 3, wherein the solvent is a solvent capable of reacting with the siloxane prepolymer, said solvent preferably being selected from
- the group of water, aliphatic alcohols, aliphatic ethers, and aromatic alcohols and mixtures thereof or
- the group of propylene glycol monomethylether, propylene glycol propyl ether, 2-propanol, water, ethanol, methanol and ethyl lactate and mixtures thereof.

5. The composition according to any of claims 1 to 4, wherein the photo reactive compound is a photo acid generator or photo initiator, in particular the photo reactive compound is capable of cross-linking the siloxane composition subject to treatment with ultraviolet light or thermally, the composition preferably containing a thermo acid generator as an additive.

6. The composition according to any of the preceding claims, wherein the concentration of the photo reactive compound is about 0.1 to 10 %, preferably about 0.5 to 5 %, calculated from the mass of the siloxane polymer.

7. The composition according to any of the preceding claims, comprising solid nanoparticles in an amount of between 5 and 50 wt-% of the composition, wherein the nanoparticles are preferably selected from the group of light scattering pigments and inorganic phosfors.

8. A siloxane composition comprising a siloxane prepolymer in a solvent phase,
- said prepolymer having a siloxane backbone formed by repeating -Si-O-units and having a molecular weight in the range of from about 1,000 to about 10,000 g/mol, said siloxane backbone exhibiting hydroxyl groups in an amount of about 5 to 70 % of the -Si-O- units and further exhibiting epoxy groups in an amount of 1 to 15 mol %, calculated from the amount of repeating units; and
- said composition further comprising 0.1 - 3%, based on the weight of the solid matter, at least one cationic photo reactive compound,
wherein the solvent phase preferably comprises a solvent seletected from the group of propylene glycol monomethylether, propylene glycol propyl ether, 2-propanol, water, ethanol, methanol and ethyl lactate and mixtures thereof.

9. A method of producing a siloxane prepolymer composition according to any of claims 1 to 8, comprising
- hydrolysing at least two different silane monomers,
- condensating the silane monomers to form a siloxane polymer having a molecular weight of about 500 to 20,000 g/mol, and
- incorporating a photo reactive compound and a solvent for the siloxane polymer, in order to formulate a siloxane prepolymer liquid composition.

10. A method of producing a siloxane prepolymer composition, comprising the steps of
- hydrolysing at least two different silane monomers,
- condensating the silane monomers to form a siloxane polymer having a molecular weight of about 500 to 20,000 g/mol,
- recovering the siloxane polymer in a solvent phase, and
- incorporating a photo reactive compound into the solvent phase,
the silane monomers including monomers containing reactive functional group(s), which is (are) capable of achieving cross-linking of siloxane polymers under the induction of the photo reactive compound, said hydrolysing and said condensation steps being carried out such that there are at least some hydroxyl groups present in the polymer, wherein the hydrolysis step is carried out in an aqueous solvent.

11. A method of using a siloxane prepolymer composition according to any of claims 1 to 8 in a lithographic method, comprising the steps of
- optionally adjusting the solid contents of the prepolymer composition material to the required film thickness of the deposited film,
- depositing the composition on a substrate to form a layer having a film thicknesses of 10 nm- 10 µm,
- optionally heat treating the deposited film,
- subjecting the deposited material layer to lithography by using a photo mask or reticle and exposing the material to UV light,
- optionally heat treating the exposed material, and
- removing the non-exposed areas of the film are removed in a development step, by contacting the layer with an aqueous basic developer solution.

12. The method according to claim 11, wherein the aqueous base developer solution has a pH of at least 7, preferably at least 9, for example at least 11, suitably at least 12, in particular about 12 to 13.

13. The method according to claim 11 or 12, wherein a film is produced having a dielectric constant of 4 or below at a frequency of 100 kHz and an index of refraction which is between 1.2 to 1.9 at a wavelength of 633 nm.

14. The method according to any of claims 11 to 13, wherein a film is produced exhibiting a cross-linking degree of 70 % or more at a UV dose of 100 mJ/cm² or less at I-line wavelength of mercury UV source.

15. The method according to any of clams 11 to 14, comprising patterning the material compositions by direct lithographic patterning, by conventional lithographic masking and etching procedure, or by imprinting and embossing.
